# EUROPEAN PATENT APPLICATION

(11) **EP 0 727 773 A1**
(43) Date of publication of application: **21.08.1996**
(21) Application number: 96300906.3
(22) Date of filing: 09.02.1996
(51) Int. Cl.: G11B 5/39, G01R 33/09

(54) **Magnetoresistive head**

(30) Priority: 16.02.1995 JP 50386/95
(71) Applicant: TDK Corporation, Chuo-ku, Tokyo-to 103 (JP)
(72) Inventor: Uno, Yasufumi, Minamisaku-gun, Nagano (JP); Matsuzaki, Mikio, Urawa-shi, Saitama (JP)
(74) Representative: Rackham, Stephen Neil

(57) **Abstract**

A magnetoresistive head has a spin valve effect element constituted by sequentially laminating at least a first thin film layer of magnetic material (23), a thin film layer of non-magnetic material (24), a second thin film layer of magnetic material (25) and a thin film layer of antiferromagnetic material (26) on a substrate (21). The first thin film layer of magnetic material (23) is formed only in a central active region corresponding to a track width (W_{T}) of the head.

## Description

The present invention relates to a magnetoresistive (MR) head utilizing the spin valve effect and to a method of manufacturing the MR head.

A spin valve effect element is known as one of elements providing the giant magnetoresistive effect. This spin valve effect element has a sandwiched structure with two magnetic material layers separated by a non-magnetic material layer. An antiferromagnetic material layer is laminated in contact with one of the two uncoupled magnetic material layers so as to produce an exchange biasing magnetic field at their boundary and to apply it to this magnetic material layer. Therefore, this one magnetic material layer receives the biasing magnetic field, whereas the other magnetic material layer receives no biasing magnetic field so that magnetization switching is introduced by different magnetic field between the two magnetic material layers. The magnetization directions of the two magnetic material layers therefore change between in parallel and in antiparallel with each other so that the electrical resistivity of this spin valve effect element greatly varies to obtain the large MR effects.

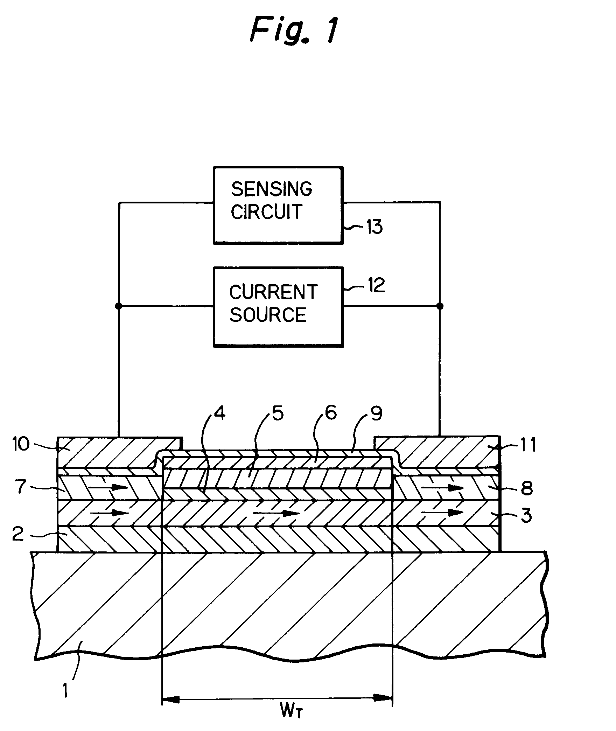

US Patent No.5,206,590 discloses a conventional MR head utilizing the above-mentioned spin valve effect. Fig. 1 schematically shows a sectional view of this MR head.

In the figure, reference numeral 1 denotes a substrate and 2 denotes an under layer deposited on the substrate 1. On the under layer 2, a first thin film layer of soft ferromagnetic material 3 is deposited. On the first layer of ferromagnetic material 3, a thin film layer of non-magnetic metallic material 4, a second thin film layer of soft ferromagnetic material 5 and a thin film layer of antiferromagnetic material 6 are sequentially deposited within a partial region namely within a central active region corresponding to the track width W_{T}. Also on the first layer of ferromagnetic material 3, thin film layers of hard ferromagnetic material 7 and 8 are deposited in regions except for the central active region W_{T} in contact with the end regions of the laminated thin film layers 4 and 5. The layers of hard ferromagnetic material 7 and 8 have high coercivety, high squareness and high resistivity and are adopted to produce a longitudinal bias for maintaining the first layer of ferromagnetic material 3 in a single domain state as indicated by the arrows in Fig. 1. In the figure, furthermore, reference numeral 9 denotes a capping layer of high resistivity material, 10 and 11 denote electrical leads of conductive material, 12 denotes a current source for providing a constant current to the MR head, and 13 denotes a sensing circuit for sensing the variation of electrical resistance of the MR head by detecting the voltage variation across the electrical leads 10 and 11.

In such the conventional MR head based upon the spin valve effect, the first thin film layer of soft ferromagnetic material 3 which operates to sense the magnetization direction is disposed not only in the central active region W_{T} but also in regions under the layers of hard ferromagnetic material 7 and 8. Thus, the effective active region operated as a MR head may become larger than the track width W_{T} resulting incorrect replay of information recorded on the magnetic medium. Furthermore, since the spin valve effect element is constituted by a very thin multilayered film, it is very difficult to form the layer of non-magnetic metallic material 4, the second layer of soft ferromagnetic material 5 and the layer of antiferromagnetic material 6 only in the central active region W_{T} on the first layer of soft ferromagnetic material 3. Namely, it is quite difficult to remove by etching only a predetermined pattern of the layer of non-magnetic metallic material 4, the second layer of soft ferromagnetic material 5 and the layer of antiferromagnetic material 6 which have been deposited and patterned by photolithography, so as to expose the surface of the first layer of soft ferromagnetic material 3. Although this process can be carried out in theory, reproductibility in the actual manufacturing processes is very poor and thus the productivity efficiency will extremely decrease.

According to a first aspect of this invention, a magnetoresistive head comprising a spin valve effect element constituted by sequentially laminating at least a first thin film layer of magnetic material, a thin film layer of non-magnetic material, a second thin film layer of magnetic material and a thin film layer of antiferromagnetic material on a substrate is characterized in that said first thin film layer of magnetic material is formed only in a central active region corresponding to a track width of the head.

According to a second aspect of this invention a method of forming a magnetoresistive head comprises the steps of:
forming a spin valve effect element by sequentially laminating at least a first thin film layer of magnetic material, a thin film layer of non-magnetic material, a second thin film layer of magnetic material and a thin film layer of antiferromagnetic material on a substrate;
forming a stencil mask for masking a central active region, corresponding to a track width (W_{T}) of the head, of said spin valve effect element;
eliminating by etching regions of said spin valve effect element unmasked by said stencil mask; and,
forming thin film layers of hard ferromagnetic material on the substrate in the regions unmasked by said stencil mask so that said thin film layers of hard ferromagnetic material are disposed adjacent to respective end faces of said first thin film layer of magnetic material to provide abutting junctions therebetween.

According to the present invention, since the first thin film layer of magnetic material which operates as a magnetization direction sensor is formed only in the central active region, an effective width of the active region of the MR head can be correctly determined to a required track width. Furthermore, since the first thin film layer of magnetic material is formed only in the central active region, a manufacturing process for etching operation can be extremely easily performed. Namely, it is not necessary for performing a difficult process to stop the etching operation just before the first thin film layer of magnetic material, but all the layers of the spin valve effect element on the substrate can be eliminated by etching. Thus, a good productivity efficiency of the MR head can be expected.

It is preferred that the head further includes thin film layers of hard ferromagnetic material or antiferromagnetic material for producing a longitudinal bias. The thin film layers of hard ferromagnetic material or antiferromagnetic material are formed adjacent to respective end faces of the first thin film layer of magnetic material so as to provide abutting junctions there between.

It is also preferred that the thin film layers of hard ferromagnetic material or antiferromagnetic material are (directly) laminated on the substrate. Furthermore, on these layers, conductive layers for electrical leads are preferably laminated.

A preferred embodiment of the present invention will now be described with reference to the accompanying drawings; in which:-
Fig. 1 schematically shows a section view of the conventional MR head utilizing the spin valve effect already described;
Fig. 2 schematically shows a sectional view of a preferred embodiment of a MR head according to the present invention; and
Figs. 3a to 3d show sectional views illustrating a part of manufacturing processes of the MR head according to the embodiment shown in Fig. 2.

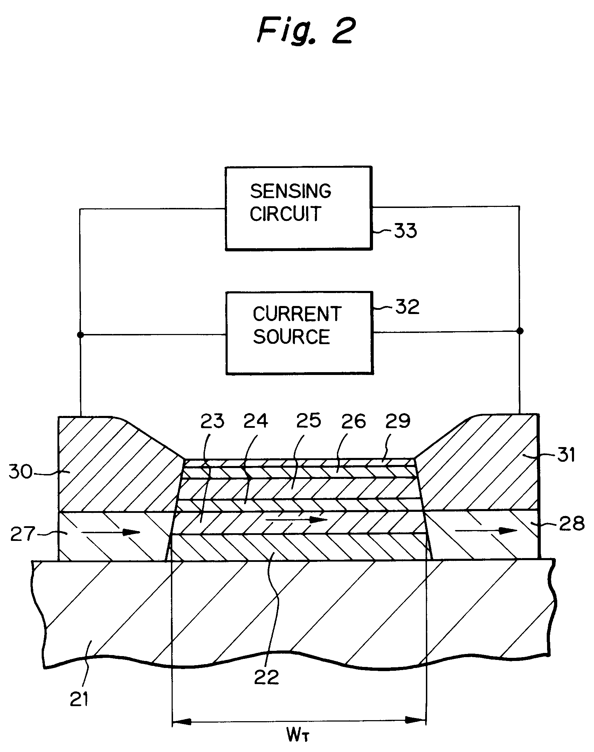

In Fig. 2, reference numeral 21 denotes a substrate made of, for example glass, ceramic or semiconductor material, and 22 denotes an under layer deposited on the substrate 21. This under layer 22 is made of a high resistivity material such as for example Ta, Ru or CrV so as to optimize the texture of the subsequent spin valve layers. If the substrate 21 itself has a high resistivity and an optimum crystal structure, the under layer 22 can be omitted.

On the under layer 22, a first thin film layer of soft ferromagnetic material 23, a thin film layer of non-magnetic metallic material 24, a second thin film layer of soft ferromagnetic material 25 and a thin film layer of antiferromagnetic material 26 are sequentially deposited in this order to form a layered spin valve effect element. The first and second layers of soft ferromagnetic material 23 and 25 are made of for example Co, Fe, Ni, NiFe, NiCo or FeCo. The thin film layer of non-magnetic metallic material 24 is made of a metallic material with a high electric conductivity such as for example Au, Ag or Cu. The thin film layer of antiferromagnetic material 26 is made of for example FeMn.

In a modified embodiment, the layered spin valve effect element may be formed by depositing the layers in an order opposite to the above-mentioned order. Namely, on the under layer, a thin film layer of antiferromagnetic material, a second thin film layer of soft ferromagnetic material, a thin film layer of non-magnetic metallic material and a first thin film layer of soft ferromagnetic material may be sequentially deposited in this order.

It should be noted that, according to this embodiment, the layered spin valve effect element including the first layer of ferromagnetic material 23 is deposited only in a central active region W_{T} corresponding to the track width. To form the layered spin valve effect element in this shape, first, the under layer 22, the first thin film layer of soft ferromagnetic material 23, the thin film layer of non-magnetic metallic material 24, the second thin film layer of soft ferromagnetic material 25 and the thin film layer of antiferromagnetic material 26 are sequentially deposited on the substrate 21 in this order, and then regions of these deposited layers other than their central active region W_{T} are eliminated by etching process so that both side end faces of the remained central active region W_{T} corresponding to the track width are tapered.

In the eliminated regions, thin film layers of hard ferromagnetic material 27 and 28 are directly formed on the substrate 21 in contact with the end regions of the layered spin valve effect element. The layers of hard ferromagnetic material 27 and 28 have high coercivety, high squareness and high resistivity and are adopted to produce a longitudinal bias for maintaining the first layer of ferromagnetic material 23 in a single domain state as indicated by the arrows in Fig. 2.

Instead of the thin film layers of hard ferromagnetic material 27 and 28, thin film layers of antiferromagnetic material may be formed in the same manner. It is desired that under films of soft ferromagnetic material are formed under the antiferromagnetic layers, but in this case the under films of soft ferromagnetic material should be magnetically coupled with the first layer of soft ferromagnetic material 23. The antiferromagnetic material for these thin film layers is selected to have a blocking temperature different from that of the antiferromagnetic material for the aforementioned thin film layer 26.

In Fig. 2, furthermore, reference numeral 29 denotes a capping layer of a high resistivity material such as for example Ta, 30 and 31 denote electrical leads of conductive material, 32 denotes a current source for providing a constant current to the MR head, and 33 denotes a sensing circuit for sensing the variation of electrical resistance of the MR head by detecting the voltage variation across the electrical leads 30 and 31.

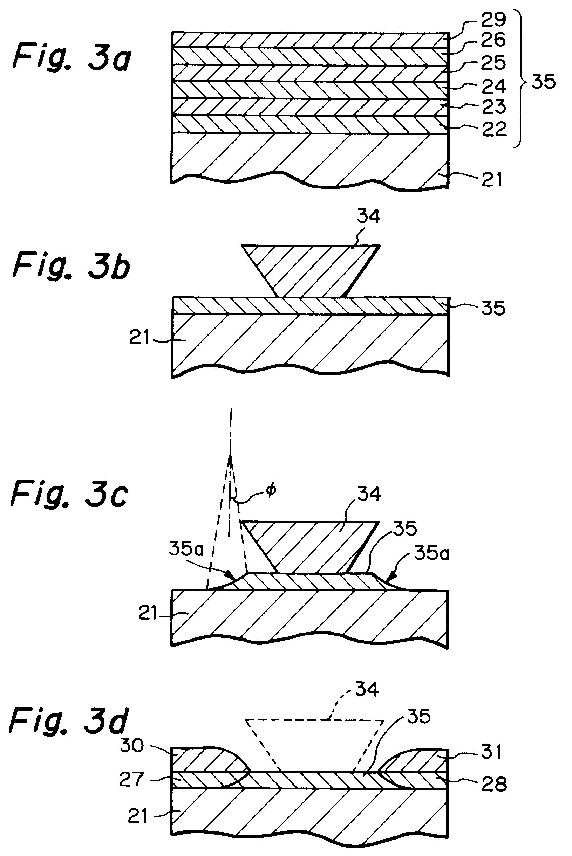

It is indicated in Fig. 2 that not only the thin film layers 27 and 28 but also the electrical leads 30 and 31 are in contact with the side ends of the layered spin valve element. However, in fact, only the thin film layers 27 and 28 are in contact with the side ends of the layered spin valve element as shown in Fig. 3d.

Since the antiferromagnetic material layer 26 is laminated in contact with the second layer of soft ferromagnetic material 25, an exchange biasing magnetic field is produced at their boundary and is applied to this second soft ferromagnetic material layer 25. Thus, magnetization of this ferromagnetic material layer 25 is fixed, whereas magnetization of the first soft ferromagnetic material layer 23 which receives no exchange biasing magnetic field can freely spin depending upon the magnetic field from the magnetic medium. The magnetization directions of the two soft ferromagnetic material layers 23 and 25 separated by the non-magnetic metallic material layer 24 therefore change between in parallel and in antiparallel with each other so that the electrical resistivity of this layered spin valve element greatly varies. These variations of the electrical resistivity are sensed by means of the current source 32 and the sensing circuit 33, and thus information written on the magnetic recording medium can be read out.

According to this embodiment, in particular, since the first soft ferromagnetic material layer 23 which operates as a magnetization direction sensor is formed only in the central active region W_{T}, an effective width of the active region of the MR head can be correctly determined to a required track width. Furthermore, since the regions except for the central active region W_{T} of all the deposited layers including the first soft ferromagnetic material layer 23 and the under layer 22 are eliminated during etching process, this etching operation can be extremely easily performed. Namely, it is not necessary for performing a difficult process to stop the etching operation just before the first ferromagnetic material layer 23, but all the layers deposited on the substrate 21 can be eliminated by etching. Thus, a good productivity efficiency of the MR head can be expected.

Hereinafter, a part of manufacturing processes of the MR head according to this embodiment will be described with reference to Figs. 3a to 3d.

As shown in Fig. 3a, on the Al-TiC substrate 21 which has been formed by depositing an under film made of for example Al₂O₃ on its surface and then by polishing the deposited surface, the under layer 22 made of Ta for example with a thickness of 70 Angstrom, the first thin film layer of soft ferromagnetic material 23 such as NiFe with a thickness of 70 Angstrom, the thin film layer of non-magnetic metallic material 24 such as Cu with a thickness of 30 Angstrom, the second thin film layer of soft ferromagnetic material 25 such as NiFe with a thickness of 70 Angstrom and the thin film layer of antiferromagnetic material 26 such as FeMn with a thickness of 100 Angstrom are sequentially deposited in this order to form a layered spin valve effect element. On the layered spin valve effect element, the capping layer of a high resistivity material 29 such as Ta with a thickness of 70 Angstrom is deposited.

Then, as shown in Fig. 3b, a photoresist film is coated over the capping layer 29 and then a stencil mask 34 of the photoresist having a pattern for masking the central active region substantially corresponding to the track width and undercut portions at its side faces is formed by performing an appropriate known method. In Fig. 3b, a reference numeral 35 denotes a layered product constituted by the under layer 22, the first soft ferromagnetic material layer 23, the non-magnetic metallic material layer 24, the second soft ferromagnetic material layer 25, the antiferromagnetic material layer 26 and the capping layer 29 (a layer product consisted of the under layer 22, the layered spin valve effect element and the capping layer 29).

Thereafter, as shown in Fig. 3c, regions unmasked by the stencil mask 34 of the layered product 35 is etched and eliminated by a single-direction etching method such as an ion milling method. During the etching process, the substrate 21 and the layered product 35 are inclined by an appropriate angle φ for example φ = 10° with respect to the incident ion beam and rotated around the central axis of the ion beam so as to eliminate the unmasked region of the layered product 35. Thus, a curved or straight tapered portion 35a is formed at the side face of this patterned layered product 35.

Then, during the rotation of the substrate 21, the hard ferromagnetic material layers 27 and 28 such as CoPt with a thickness of 300 Angstrom and the electrical leads of conductive material 30 and 31 such as Ta with a thickness of 1000 Angstrom are sequentially deposited by sputtering. In this case, an under layer of TiW with a thickness of 100 Angstrom is preferably formed prior to the Ta leads. Then, as shown in Fig. 3d, the stencil mask 34 is removed by a lift-off process. CoPt, Ta and TiW which may be deposited on the stencil mask 34 are removed together with the stencil mask 34.

In this embodiment, abutting junctions for electrical and magnetic continuity of the layered spin valve effect element to the respective hard ferromagnetic material layers 27 and 28 are tapered so that these abutting junctions can be easily and quickly formed. However, the abutting junctions are not limited to this tapered shape but can be formed in any optional shape.

The length of the abutting junctions along its tapered contour is preferably 3 to 5 times as long as the thickness of the layered spin valve effect element. This is because a length of about 0.1 to 0.3 µm is necessary for the abutting junctions and most of the spin valve effect elements will have a thickness of 300 to 600 Angstrom. If the thickness of the spin valve effect element is less than 300 Angstrom, the electrical resistance of the MR element will become extremely high for applying appropriate sense current. Contrary to this, if the thickness of the spin valve effect element is more than 600 Angstrom, reading gap of the MR head will become too wide. If the length of the abutting junctions along its tapered contour is shorter than 0.1 µm, enough electrical and magnetic continuity cannot be expected. Also, if the length of the abutting junctions along its tapered contour is longer than 0.3 µm, undesirable off-track characteristics may be introduced because the track width of the MR head will be about 1 µm.

## Claims

1. A magnetoresistive head comprising a spin valve effect element constituted by sequentially laminating at least a first thin film layer of magnetic material (23), a thin film layer of non-magnetic material (24), a second thin film layer of magnetic material (25) and a thin film layer of antiferromagnetic material (26) on a substrate (21), characterized in that said first thin film layer of magnetic material (23) is formed only in a central active region corresponding to a track width (W_{T}) of the head.

2. A head as claimed in Claim 1, wherein said head further comprises thin film layers of hard ferromagnetic material (27,28) for producing a longitudinal bias, said thin film layers of hard ferromagnetic material (27,28) being formed adjacent to respective end faces of said first thin film layer of magnetic material (23) so as to provide abutting junctions therebetween.

3. A head as claimed in Claim 2, wherein said thin film layers of hard ferromagnetic material (27,28) are directly laminated on said substrate (21).

4. A head as claimed in Claims 2 or 3, wherein said head further comprises conductive layers (30,31) for electrical leads laminated on said thin film layers of hard ferromagnetic material (27,28).

5. A head as claimed in Claim 1, wherein said head further comprises thin film layers of antiferromagnetic material for producing a longitudinal bias, said thin film layers of antiferromagnetic material being formed adjacent to respective end faces of said first thin film layer of magnetic material (23) so as to provide abutting junctions therebetween.

6. A head as claimed in Claim 5, wherein said thin film layers of antiferromagnetic material are laminated on said substrate (21).

7. A head as claimed in Claims 5 or 6, wherein said head further comprises conductive layers (30,31) for electrical leads laminated on said thin film layers of antiferromagnetic material.

8. A method of manufacturing a magnetoresistive head, said method comprising the steps of:
forming a spin valve effect element by sequentially laminating at least a first thin film layer of magnetic material (23), a thin film layer of non-magnetic material (24), a second thin film layer of magnetic material (25) and a thin film layer of antiferromagnetic (26) material on a substrate (21);
forming a stencil mask (34) for masking a central active region, corresponding to a track width (W_{T}) of the head, of said spin valve effect element;
eliminating by etching regions of said spin valve effect element unmasked by said stencil mask; and,
forming thin film layers of hard ferromagnetic material (27,28) on the substrate (21) in the regions unmasked by said stencil mask (34) so that said thin film layers of hard ferromagnetic material (27,28) are disposed adjacent to respective end faces of said first thin film layer of magnetic material to provide abutting junctions therebetween.

9. A method as claimed in Claim 8, wherein said method further comprises a step of forming conductive layers (30,31) for electrical leads on said thin film layers of hard ferromagnetic material (27,28), and a step of removing said stencil mask (34) after said conductive layers (30,31) forming step.
